# EUROPEAN PATENT APPLICATION

(11) **EP 3 761 506 A1**
(43) Date of publication of application: **06.01.2021**
(21) Application number: 19761155.1
(22) Date of filing: 26.02.2019
(51) Int. Cl.: H03H 9/25

(54) **COMPOSITE SUBSTRATE AND PIEZOELECTRIC ELEMENT**

(30) Priority: 02.03.2018 JP 2018037267
(71) Applicant: Kyocera Corporation, Kyoto-shi, Kyoto 612-8501 (JP)
(72) Inventor: NARAHARA, Yoshihide, Kyoto-shi, Kyoto 612-8501 (JP); UMEHARA, Motohiro, Kyoto-shi, Kyoto 612-8501 (JP); KAJIHARA, Mitsuhiro, Kyoto-shi, Kyoto 612-8501 (JP)
(74) Representative: Viering, Jentschura & Partner mbB Patent- und Rechtsanwälte
(86) International application number: PCT/JP2019/007206
(87) International publication number: WO 2019/167918

(57) **Abstract**

The composite substrate of the present disclosure has a piezoelectric substrate having a first surface and a second surface opposing the first surface, a support substrate having a third surface in contact with the second surface and a fourth surface opposing the third surface, and a through hole penetrating from the first surface to the fourth surface. The through hole has a tapered shape having a diameter decreasing from the first surface to the fourth surface and has a stepped surface having a decreasing diameter in the support substrate. The piezoelectric device of the present disclosure comprises the composite substrate and a conductor located within the through hole.

## Description

### TECHNICAL FIELD

The present disclosure relates to a composite substrate having a structure in which a piezoelectric substrate and a support substrate are bonded together, and a piezoelectric device with this composite substrate.

### BACKGROUND ART

In recent years, there has been a demand for miniaturization and higher performance of piezoelectric devices such as surface acoustic wave devices used in communication devices such as mobile phones. As a small and high performance piezoelectric device, there is a device that supplies electrical signals to the element electrodes formed on a piezoelectric substrate through a conductor formed in a through hole penetrating a composite substrate composed of the piezoelectric substrate and a support substrate bonded together.

As such composite substrates for piezoelectric devices, Patent Document 1 suggests a composite substrate in which both substrates are bonded together and a through hole is formed. Patent Documents 2 and 3 suggest a composite substrate in which holes are formed in both substrates and then bonded together.

### PRIOR ART DOCUMENTS

### PATENT DOCUMENTS

Patent Document 1: Japanese Unexamined Patent Publication No. 2011-130385
Patent Document 1: Japanese Unexamined Patent Publication No. 2003-37471
Patent Document 1: Japanese Unexamined Patent Publication No. 2010-50539

### SUMMARY OF THE INVENTION

The composite substrate of the present disclosure includes a piezoelectric substrate having a first surface and a second surface opposing the first surface, a support substrate having a third surface in contact with the second surface and a fourth surface opposing the third surface, and a through hole penetrating from the first surface to the fourth surface. The through hole has a tapered shape having a diameter decreasing from the first surface to the fourth surface and has a stepped surface at which a diameter decreases in the support substrate. The piezoelectric device of the present disclosure includes the composite substrate and a conductor located within the through hole.

### BRIEF DESCRIPTION OF THE DRAWINGS

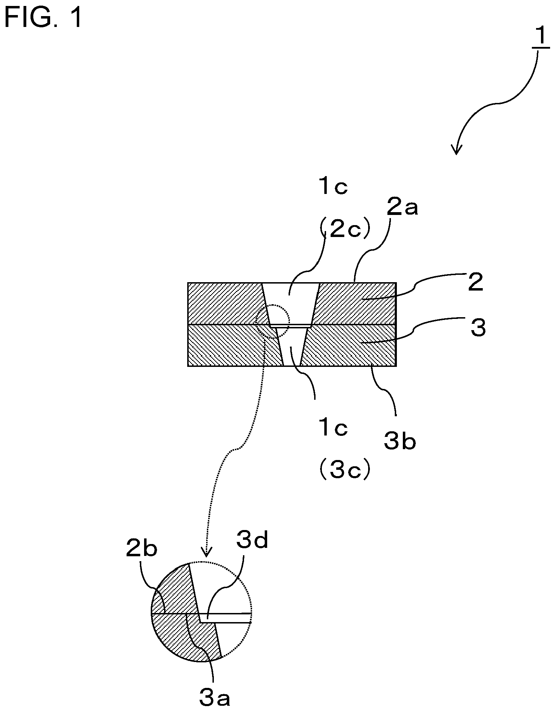

Fig. 1 is a schematic sectional view showing an example of the composite substrate of the present disclosure.

### EMBODIMENTS FOR CARRYING OUT THE INVENTION

The composite substrate and the piezoelectric device of the present disclosure will be described with reference to the figure.

### <Composite Substrate>

Fig. 1 shows a schematic sectional view of a composite substrate 1 of the present disclosure. The composite substrate 1 of the present disclosure has a piezoelectric substrate 2 having a first surface 2a and a second surface 2b opposing the first surface 2a, a support substrate 3 having a third surface 3a coming in contact with the second surface 2b and a fourth surface 3b opposing the third surface 3a, and a through hole 1c penetrating from the first surface 2a to the fourth surface 3b. The through hole 1c has a tapered shape with a diameter decreasing from the first surface 2a to the fourth surface 3b. The through hole 1c has a stepped surface 3d at which the diameter of the through hole 1c is decreased in the support substrate 3. Fig. 1 shows an example in which the stepped surface 3d is substantially parallel to the third surface 3a. The sectional shape perpendicular to the penetrating direction of the through hole 1c is not particularly restricted. The sectional shape perpendicular to the penetrating direction of the through hole 1c is, for example, circular. The dimensions of the composite substrate 1, for example, are 4 inches to 8 inches in diameter, the thickness of the support substrate 3 is 0.08 mm to 1.5 mm, and the thickness of the piezoelectric substrate 2 is 0.1 µm to 50 µm.

### <Piezoelectric Device>

The composite substrate 1 of the present disclosure is used as a composite substrate 1 for piezoelectric devices such as surface acoustic wave devices. A plurality of piezoelectric devices is formed on a single composite substrate 1. An element electrode is formed on the first surface 2a of the piezoelectric substrate 2. An external electrode is formed on the fourth surface 3b of the support substrate 3. A conductor made of a conductive material such as copper is formed inside the through hole 1c. This conductor is connected to the element electrode on the first surface 2a and the external electrode on the fourth surface 3b. The conductor is formed inside the through hole 1c by vapor deposition, sputtering, or other methods.

The composite substrate 1 and the piezoelectric device of the present disclosure have the through hole 1c. The through hole 1c has a tapered shape with a diameter decreasing from the first surface 2a to the fourth surface 3b and has a stepped surface 3d with a diameter decreasing in the support substrate 3. Thus, the composite substrate 1 and the piezoelectric device of the present disclosure have high adhesion between the inner surface of the through hole 1c and the conductor. Although the conductor located on the stepped surface 3d has a part which is bended (bending part), it is not located on the sticking surface of the second surface 2b and the third surface 3a. Therefore, it is less likely to occur a detachment of the sticking surface between the second surface 2b and the third surface 3a. Since the stepped surface 3d is located in the supporting substrate 3, there is no risk of damage to the element electrodes (piezoelectric devices) of the piezoelectric substrate 2. As a result, the composite substrate 1 and the piezoelectric device of the present disclosure have excellent reliability and can be used for a long period of time.

In the through hole 1c, an arithmetic mean roughness Ra of the stepped surface 3d and the region on the first surface 2a side from the stepped surface 3d may be smaller than an arithmetic mean roughness Ra of the region on the fourth surface 3b side from the stepped surface 3d.

When Such a configuration is satisfied, the piezoelectric substrate 2 is less likely to be damaged, the stress concentration applied to the bending part is suppressed, and the region on the fourth surface 3b side has higher adhesion than the stepped surface 3d. Therefore, the reliability of the composite substrate 1 and the piezoelectric device is increased.

In the through hole 1c, the stepped surface 3d and the region on the first surface 2a side from the stepped surface 3d has a small arithmetic mean roughness Ra and a surface property that is difficult to concentrate stress. Therefore, the piezoelectric substrate 2 is less likely to be damaged and the stress concentration applied to the bending part is suppressed.

In the through hole 1c, the adhesion of the region on the fourth surface 3b side being higher than that of the stepped surface 3d is due to an anchor effect.

### <Piezoelectric Substrate and Support Substrate>

The piezoelectric substrate 2 is composed of piezoelectric materials such as lithium tantalate (LT), lithium niobate (LN), zinc oxide, and crystal. The support substrate 3 is composed of a material with higher mechanical strength than the piezoelectric substrate 2. The support substrate 3 is configured from various ceramics, such as sapphire, silicon, silicon carbide, LN, alumina. Among them, sapphire has excellent mechanical strength, insulation, and heat dissipation properties, making it a suitable material for the support substrate 3.

### <Manufacturing Method>

An example of a manufacturing method of the composite substrate 1 of the present disclosure is shown below.

First, the piezoelectric substrate 2 having the first surface 2a and the second surface 2b opposing the first surface 2a, and the support substrate 3 having the third surface 3a and the fourth surface 3b opposing the third surface 3a are prepared.

Next, it is processed to form a tapered first hole 3c, which penetrates from the third surface 3a side to the fourth surface 3b side of the support substrate 3.

Then, the third surface 3a of the support substrate 3 in which the first hole 3c is formed and the second surface 2b of the piezoelectric substrate 2 are bonded together.

Finally, a process forming a tapered second hole 2c, which penetrates from the first surface 2a side to the second surface 2b side of the piezoelectric substrate 2 is performed. At this time, the hole diameter of the second hole 2c on the second surface 2b is processed so as to be larger than the hole diameter in the third surface 3a at the time of bonding, and the hole diameter on the third surface 3a side (the piezoelectric substrate 2 side of the first hole 3c) is processed so as to be larger in diameter than when it is bonded.

The holes can be formed by laser-processing, blasting or drilling. When sapphire is used as the support substrate 3 and the first hole 3c is formed by laser processing, a short pulsed UV laser using harmonics such as a YAG laser is suitable. When the support substrate 3 is laser-processed, debris scattered from the processing area during processing adheres to the surface and processed surface of the support substrate 3. Debris will adversely affect subsequent manufacturing processes and product characteristics. Therefore, debris is removed by etching or other methods. For debris removal of the support substrate 3 comprising sapphire, for example, etching with hydrochloric acid, nitric acid, hydrofluoric acid, phosphoric acid, sodium tetraborate melt, KOH melt, and NaOH melt can be used.

The piezoelectric substrate 2 and the support substrate 3 are bonded together by direct bonding without using an adhesive material, or by bonding with an adhesive material. In direct bonding, the piezoelectric substrate 2 and the support substrate 3 are joined by heating and/or pressurizing them in vacuum, in air or in a predetermined atmosphere. Stresses are generated in the piezoelectric substrate 2 and the support substrate 3 due to the temperature at the time of bonding and the difference in the thermal expansion rate between the piezoelectric substrate 2 and the support substrate 3, which may cause damage and defective processing accuracy. In order to reduce such stresses, it is preferable that a bonding temperature is low. For this purpose, the second surface 2b of the piezoelectric substrate 2 and the third surface 3a of the support substrate 3 may be joined after activation treatment is applied by a method such as plasma treatment.

After the piezoelectric substrate 2 and the support substrate 3 are bonded together, the second hole 2c is formed. The second hole 2c may be formed after grinding the first surface 2a of the piezoelectric substrate 2 using a lapping device or the like to reduce the thickness of the piezoelectric substrate 2.

In general, piezoelectric materials have low mechanical strength. Therefore, it is preferred to form the second hole 2c on the piezoelectric substrate 2 by chemical treatment such as wet etching and dry etching. If the piezoelectric substrate 2 is made of LT or LN, it can be formed by a combination of mask formation by photolithography technique and reactive ion etching using a halogenated compound gas such as CF₄.

In general, an etched surface has a smaller surface roughness than a laser processed surface. The surface roughness can be expressed, for example, as the arithmetic mean roughness Ra. Of the through hole 1c, if the first hole 3c is formed by laser processing and the stepped surface 3d and the second hole 2c are formed by etching, in the through hole 1c, the surface roughness of the stepped surface 3d and the region on the first surface 2a side (piezoelectric substrate 2 side) from the stepped surface 3d can be smaller than that of the region on the fourth surface 3b side (support substrate 3 side) from the stepped surface 3d.

In the composite substrate and the piezoelectric device of the present disclosure, a tapered through hole decreasing diameter from one surface of the substrate (a first surface of the piezoelectric substrate) to the other surface (a fourth surface of the support substrate) has a stepped surface decreasing diameter in the support substrate. As a result, adhesion between the inner surface of the through hole and the conductor is increased, and it is less likely to cause a detachment of the bonding surface of the substrate and stress concentration on the piezoelectric substrate having no stepped surface. Therefore, a composite substrate and a piezoelectric device with excellent reliability can be provided.

The following methods are used as a manufacturing method of the composite substrate 1. For example, the piezoelectric substrate 2 and the support substrate 3 are first bonded together, and then a through hole having a small diameter is formed. After that, a through hole 3c is formed by processing to widen the diameter of the small through hole on the piezoelectric substrate 2 side in the piezoelectric substrate 2 and the support substrate 3.

Alternatively, the second hole 2c having a tapered shape is first formed in the piezoelectric substrate 2, and the first hole 3c having an overall tapered shape and a stepped part 3d is formed in the support substrate 3. Then, by bonding the piezoelectric substrate 2 and the support substrate 3 together, the through hole 3c in which the second hole 2c and the first hole 3c are connected may be formed.

Although the embodiments of the present disclosure have been described above, the present disclosure is not limited to the above-described embodiments, and various improvements and changes may be made within the scope of the claims.

### DESCRIPTION OF THE REFERENCE NUMERALS

- 1:: Composite Substrate
- 1c:: Through hole
- 2:: Piezoelectric Substrate
- 2a:: First Surface
- 2b:: Second Surface
- 2c:: Second Hole
- 3:: Support Substrate
- 3a:: Third Surface
- 3b:: Fourth Surface
- 3c:: First Hole
- 3d:: Stepped Surface

## Claims

1. A composite substrate comprising:
a piezoelectric substrate having a first surface and a second surface opposing the first surface,
a support substrate having a third surface in contact with the second surface and a fourth surface opposing the third surface, and
a through hole penetrating from the first surface to the fourth surface,
wherein the through hole has a tapered shape having a diameter decreasing from the first surface to the fourth surface and a stepped surface at which a diameter decreases in the support substrate.

2. The composite substrate according to Claim 1, wherein the piezoelectric substrate is a lithium tantalate substrate or a lithium niobate substrate.

3. The composite substrate according to Claims 1 or 2, wherein the support substrate is a sapphire substrate.

4. The composite substrate according to any of Claims 1 to 3, wherein in the through hole, an arithmetic mean roughness Ra of the stepped surface and the region on the first surface side from the stepped surface is smaller than an arithmetic mean roughness Ra of the region on the fourth surface side from the stepped surface.

5. The composite substrate according to any of Claims 1 to 4, wherein the stepped surface is substantially parallel to the third surface.

6. A piezoelectric device comprising the composite substrate according to any of Claims 1 to 5, and a conductor located within the through hole.

7. The piezoelectric device according to Claim 6, which is a surface acoustic wave device.
